# FASCICULE DE BREVET EUROPEEN

(11) **EP 2 232 293 B1**
(45) Date de publication et mention de la délivrance du brevet: **01.01.2014**
(21) Numéro de dépôt: 08848672.5
(22) Date de dépôt: 14.11.2008
(51) Int. Cl.: F41G 7/22, F41H 13/00, G01S 7/495, H01L 27/146, H04K 3/00, H04N 5/33

(54) **SYSTEME DE BROUILLAGE ET D'ENDOMMAGEMENT DE CAPTEUR IR**
SYSTEM ZUM STÖREN UND BESCHÄDIGEN EINES IR-SENSORS
SYSTEM FOR JAMMING AND DAMAGING AN IR SENSOR

(30) Priorité: 16.11.2007 FR 0708056
(43) Date de publication de la demande: 29.09.2010
(73) Titulaire: THALES, 92200 Neuilly-sur-Seine (FR)
(72) Inventeur: BOUCHARDY, Anne-Marie, F-92260 Fontenay Aux Roses (FR); CHARASSE, Rémi, F-94230 Cachan (FR); GROSSETETE, Dominique, F-91300 Massy (FR)
(74) Mandataire: Henriot, Marie-Pierre
(86) Numéro de dépôt international: PCT/EP2008/065534
(87) Numéro de publication internationale: WO 2009/063038

(56) Documents cités:
- EP-A- 0 844 495
- EP-A- 1 361 613
- WO-A-2005/109031
- WO-A-2007/085942
- WO-A1-2005/045465
- US-A- 4 779 004
- US-A- 5 629 522
- BIGAS ET AL: "Review of CMOS image sensors" MICROELECTRONICS JOURNAL, MACKINTOSH PUBLICATIONS LTD. LUTON, GB, vol. 37, no. 5, 1 mai 2006 (2006-05-01), pages 433-451, XP005324238 ISSN: 0026-2692
- CHIH-CHENG HSIEH ET AL: "Focal-Plane-Arrays and CMOS Readout Techniques of Infrared Imaging Systems" IEEE TRANSACTIONS ON CIRCUITS AND SYSTEMS FOR VIDEO TECHNOLOGY, IEEE SERVICE CENTER, PISCATAWAY, NJ, US, vol. 7, no. 4, 1 août 1997 (1997-08-01), XP011014404 ISSN: 1051-8215

## Description

Le domaine de l'invention est celui de la contre-mesure et plus précisément de systèmes permettant de brouiller et éventuellement d'endommager également un autodirecteur de missile ou une caméra de conduite de tir menaçant un aéronef porteur du système.

Ces dernières années, il est apparu que les avions civils pouvaient aussi faire l'objet d'attaque, par exemple par des groupes terroristes équipés de missiles portables sol-air existant en grand nombre suite aux derniers conflits dans le monde. Il devient donc nécessaire de protéger ces avions contre ces menaces. Les avions civils, décollant d'aéroports pouvant être situés en ville, nécessitent des moyens d'autoprotection sophistiqués qui doivent répondre à certains critères dont en particulier, une couverture de l'espace de 2π stéradians autour de l'appareil (l'avion étant vulnérable au sol et en vol), pas de modification de la traînée aérodynamique, un poids et un encombrement faible, une garantie de sécurité vis à vis des personnes, un faible coût.

Les équipements utilisés aujourd'hui pour assurer des missions d'autoprotection contre les tirs de missiles comportent de façon connue une caméra infrarouge qui, une fois qu'un missile est détecté, par exemple par un détecteur ultra-violet et/ou un radar, repère le missile grâce à sa flamme de combustion et/ou sa signature radar. Un exemple de système de détection est décrit dans le document EP 0 844 405. Cette poursuite passive est aussi parfois assurée par une caméra sensible aux rayonnements UV ou IR qui permet de réaliser rapidement et à coup sûr l'accrochage de la poursuite IR sur le missile à neutraliser. En effet dans le cas de missiles sol-air, la détection par des rayonnements UV ou IR permet de distinguer le sol du missile et donc d'indiquer au dispositif de brouillage le point chaud renvoyé par le missile parmi les points chauds renvoyés à la fois par le missile et par le sol.

La poursuite active du missile est assurée par l'émission d'un faisceau laser, dont l'orientation est assurée par un dispositif d'orientation de la ligne de visée, associé à un détecteur laser de type détecteur 4 cadrans, qui détecte le flux laser réfléchi par l'optique de l'autodirecteur du missile, grâce à l'effet dit « oeil de chat ». Les lasers utilisés par ces équipements peuvent être des lasers infrarouges fonctionnant à une puissance d'environ 10 Watt moyens. Le laser, dit laser de brouillage, envoie alors un signal adapté au mode de fonctionnement de l'autodirecteur du missile (code obtenu par modulation de fréquence ou modulation d'amplitude des impulsions laser) sur l'optique de celui-ci afin de le leurrer. Pour pouvoir contrer différents types d'autodirecteurs de missiles, le dispositif de brouillage dispose de plusieurs codes de brouillage. Mais le nombre de codes de brouillage est limité en raison de la courte durée des impulsions laser (de l'ordre de 15 ns) et de leur faible facteur de forme (de l'ordre de 10⁻³)_{.}

Cependant, l'architecture de ces équipements adaptés à des porteurs militaires est coûteuse et lourde, et la traînée aérodynamique générée est totalement incompatible des besoins civils, sauf à les rendre escamotables ce qui pénaliserait encore plus les bilans de masse et donc la charge utile pour ces mêmes avions.

Il existe également des systèmes d'endommagement équipés d'un laser impulsionnel et basés sur une poursuite active. Compte tenu des fortes puissances du laser d'endommagement, de l'ordre de quelques Joules par impulsions, la sécurité oculaire n'est pas assurée. Ces systèmes nécessitent une bonne précision de pointage notamment pour pouvoir pointer à longue distance (plus de 5km) dans le cas de missiles air-air ou sol-air : ils comportent à cet effet un dispositif de pointage du laser d'endommagement qui augmente d'autant l'encombrement du système.

Un exemple de système de brouillage utilisant des diodes de forte puissance (1 KW/cm²) est décrit dans la demande de brevet WO 2005/045465.

Une solution pour obtenir un système de brouillage et d'endommagement IR consiste à associer ces 2 systèmes. On obtient un système à 2 voies optiques, l'une incluant le laser de brouillage, l'autre le laser d'endommagement, mais le système obtenu cumule les inconvénients précités : peu de codes de brouillage lorsqu'il fonctionne en mode brouillage, pas de sécurité oculaire lorsqu'il fonctionne en mode endommagement. De plus le système résultant présente des dimensions trop importantes incompatibles des contraintes aérodynamiques, de poids et de volume d'un système aéroporté notamment lorsque installé à bord d'un hélicoptère, d'un avion civil ou de combat.

La présente invention permet de remédier aux inconvénients précités en proposant un système de protection antimissile avec un module optronique d'encombrement réduit, permettant de s'adapter aux contraintes des avions civils.

Plus précisément l'invention a pour objet un système de brouillage de capteur IR qui comprend :
- un dispositif d'émission IR pour le brouillage, comprenant plusieurs diodes laser (111), chaque diode laser étant apte à émettre à une longueur d'onde λ différente,
- un détecteur d'impulsions comportant une matrice de photodétecteurs IR, chaque photo détecteur comprenant un transducteur et un intégrateur.
Il est principalement caractérisé en ce que
- chaque diode laser est apte à fonctionner en mode quasi-continu, c'est-à-dire avec un facteur de forme > 0,3,
- et chaque photo détecteur comprend des moyens :
- d'ouverture de l'intégrateur pendant la réception de chaque impulsion puis d'obturation de l'intégrateur entre deux réceptions,
- de sommation des charges intégrées par l'intégrateur sur plusieurs impulsions,
- et de lecture de la somme des charges intégrées sur plusieurs impulsions.

Selon une caractéristique de l'invention, les moyens d'ouverture et d'obturation de l'intégrateur comprennent un circuit de démultiplexage intercalé entre le transducteur et l'intégrateur.

De préférence, l'intégrateur comporte un transistor d'injection MOSFET monté en grille commune, un amplificateur de contre-réaction différentiel inverseur cascadé placé entre l'entrée du transistor d'injection et la grille de ce transistor, une capacité d'intégration.

Les longueurs d'onde des diodes laser sont typiquement comprises entre 2 et 5 µm.

Selon une caractéristique de l'invention, le système comprend en outre un équipement d'endommagement comportant un dispositif d'émission IR pour l'endommagement.

De préférence, le système comprenant une voie optique d'imagerie pour la détection et une voie optique pour l'endommagement, il comporte un dispositif d'harmonisation comprenant un détecteur IR et des composants optiques aptes à harmoniser en permanence les 2 voies.

Ce détecteur IR est avantageusement commun à la voie imagerie et à la voie harmonisation.

Selon une caractéristique de l'invention, le système comprend une seule pupille d'entrée commune aux deux voies.

D'autres caractéristiques et avantages de l'invention apparaîtront à la lecture de la description détaillée qui suit, faite à titre d'exemple non limitatif et en référence aux dessins annexés dans lesquels :
la figure 1 illustre schématiquement le fonctionnement d'un détecteur utilisé dans un système de brouillage selon l'invention,
la figure 2 représente schématiquement les principaux éléments d'un tel détecteur,
la figure 3 représente schématiquement les principaux éléments d'un exemple de système de brouillage selon l'invention,
la figure 4 représente schématiquement les principaux éléments d'un exemple de système de brouillage et d'endommagement selon l'invention,
la figure 5 représente schématiquement les principaux éléments de la configuration optique d'un exemple de système de brouillage et d'endommagement selon l'invention.

D'une figure à l'autre, les mêmes éléments sont repérés par les mêmes références.

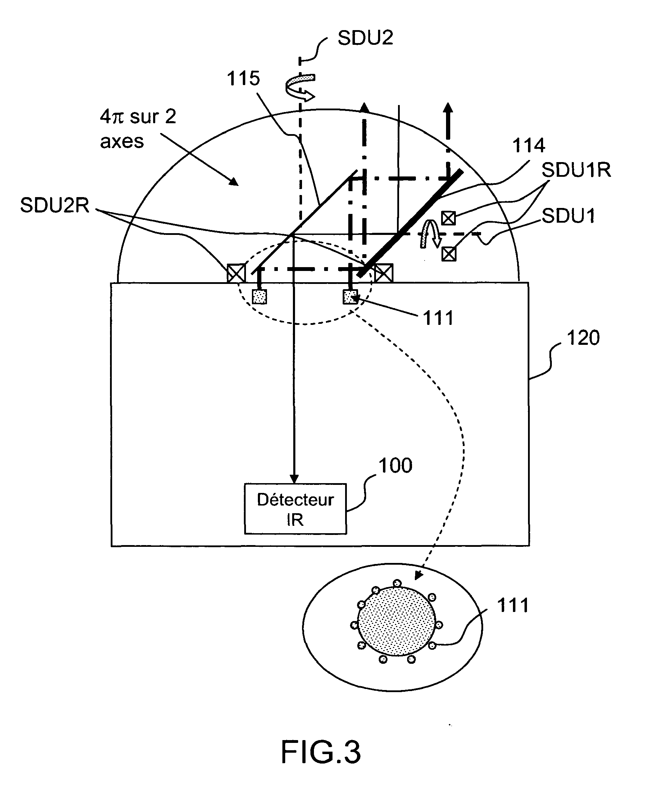

Comme le montre la figure 3, un système de brouillage IR comprend en particulier :
- un dispositif d'émission IR pour le brouillage,
- un détecteur IR 100.

Selon l'invention, le dispositif d'émission IR pour le brouillage comprend plusieurs diodes laser 111 par exemple quelques dizaines de diodes disposées sur un cercle que l'on voit plus en détail dans le bas de la figure. Ainsi on peut répartir sur ces diodes la puissance utilisée habituellement avec une seule source laser et utiliser des diodes de classe 1 au lieu d'un laser de classe 4. Ces classes laser correspondent à des contraintes d'utilisation dues à la sécurité oculaire. La classe 1 est la moins contraignante et la classe 4 la plus contraignante. Les contraintes de sécurité sont alors assurées sans qu'il soit nécessaire de prendre des précautions particulières. Chaque diode laser est apte à émettre des impulsions à une longueur d'onde λ différente, et à fonctionner en mode quasi-continu, c'est-à-dire avec un facteur de forme très supérieur à 0,1, ce qui permet d'accroître considérablement le nombre de codes de brouillage. Avec des impulsions assez larges qui durent typiquement environ 100 ns et un facteur de forme d'environ 0,5, le nombre de codes de brouillage peut aller jusqu'à au moins 50.

Cet ensemble de diodes est associé à un dispositif optomécanique d'orientation de la ligne de visée ayant un degré de rotation de 2 π sur 2 axes, qui permet d'adresser un demi espace. L'adressage de 2 π est assuré selon un axe par un miroir 114 mobile en rotation de +/-90° autour de l'axe SDU1 par rapport à sa position canonique. L'adressage de 2 π selon le second axe est assuré par une rotation de 360° autour de l'axe SDU2 de l'ensemble optique constitué des miroirs 114 et 115. Des roulements SDU1R et SDU2R permettent d'assurer la rotation des axes SDU1 et SDU2.

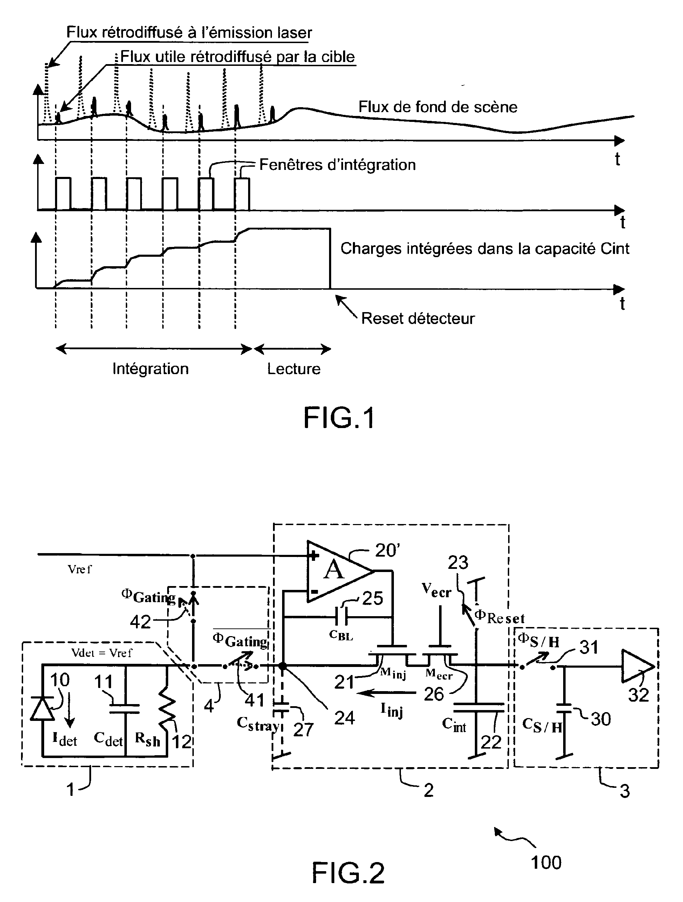

Le détecteur IR 100 selon l'invention, décrit en relation avec la figure 2 comprend une matrice de photodétecteurs. On rappelle que chaque photodétecteur comprend un transducteur 1 tel qu'une photodiode qui convertit les photons reçus en électrons proportionnellement à l'éclairement reçu ; ces charges électriques sont ensuite intégrées par un intégrateur 2 et proportionnellement converties en tension. Un circuit de lecture multiplexe les signaux de lecture issus de tous les intégrateurs et génère un signal vidéo de sortie contenant les informations de luminance du détecteur matriciel.

L'obturation du détecteur pendant l'émission d'une impulsion est actuellement réalisée soit par maintien sous reset de l'intégrateur associé à chaque photodiode, soit par dérivation du courant des photodiodes en amont de l'intégrateur. De préférence, la dérive du courant avant l'entrée de l'intégrateur est activée avant et juste après la détection de l'impulsion, la durée effective de l'intégration étant ainsi limitée à une tranche temporelle extrêmement courte qui permet une meilleure identification de la cible en éliminant l'information en provenance de l'arrière plan de la scène et/ou provenant du flux parasite rétrodiffusé à chaque émission par l'atmosphère ainsi que par l'optique du dispositif d'imagerie.

Les détecteurs existant actuellement souffrent de plusieurs inconvénients. En effet :
- Chaque illumination et acquisition doit être espacée de plusieurs millisecondes, nécessaires à la lecture du détecteur puis à sa ré-initialisation ; un tel détecteur est ainsi limité à une cadence d'environ 10 Hz, voire à une perte d'information entre 2 impulsions.
- De tels détecteurs fonctionnent avec une post-intégration classique c'est-à-dire hors plan focal, avec une lecture pour chaque impulsion ce qui augmente le bruit de lecture lors de cette phase de post-intégration.

Le détecteur 100 selon l'invention comprend des moyens :
- d'ouverture de l'intégrateur pendant la réception de chaque impulsion puis d'obturation de l'intégrateur entre deux réceptions,
- de sommation des charges intégrées par l'intégrateur sur plusieurs impulsions,
- et de lecture de la somme des charges intégrées sur plusieurs impulsions.

Ce fonctionnement est illustré figure 1 sur laquelle sont tout d'abord représentés en fonction du temps, le flux utile correspondant aux impulsions rétro-réfléchies par la cible et le flux parasite provenant du fond de scène et celui résultant de la rétro diffusion des impulsions émises par l'atmosphérique et par l'optique du dispositif. Dessous sont indiquées la succession des fenêtres d'intégration, l'intégration étant désactivée lorsque le photo détecteur est optiquement obturé c'est-à-dire entre deux impulsions rétro réfléchies par la cible ; le flux rétro diffusé à l'émission est ainsi éliminé. Au fur et à mesure que ces fenêtres d'intégration se succèdent, les charges intégrées par la capacité d'intégration 22 du photo détecteur s'accumulent pour être lue en une fois après réception de plusieurs impulsions.

L'ouverture de l'intégrateur 2 est avantageusement obtenue par deux commutateurs 41, 42 fonctionnant en opposition de phase, représentés figure 2. L'obturation de l'intégrateur est obtenue par fermeture d'un premier commutateur 42 et ouverture simultanée du deuxième commutateur 41. La fermeture du premier commutateur 42 connecte le transducteur 1 à une tension de référence Vref via la faible résistance du commutateur, et l'ouverture du second commutateur 41 isole le photo détecteur de son intégrateur 2. La reconnexion de l'intégrateur au photo détecteur est obtenue par ouverture du premier commutateur 42 et fermeture simultanée du deuxième commutateur 41.

On va à présent décrire un exemple de photo détecteur selon l'invention. Il s'agit d'un détecteur de type à injection directe contre-réactionnée ou « BDI » décrit en relation avec la figure 2, qui comprend :
- un transducteur 1 tel qu'une photodiode 10 avec en parallèle une capacité de détection 11,
- un intégrateur 2 qui comprend
   ○ un transistor 21 MOSFET (Minj) monté en grille commune et utilisé comme transistor d'injection,
   ○ un amplificateur-op inverseur 20 entre le transducteur 1 et un transistor d'injection 21, ayant une fonction de contre-réaction permettant de réduire l'impédance du transistor d'injection proportionnellement au gain de l'ampli et en conséquence d'augmenter dans les mêmes proportions la bande passante de l'injection,
   ○ une capacité d'intégration 22 et son transistor de remise à zéro 23.

Ce détecteur comprend avantageusement un circuit de mémorisation 3 incluant une capacité de mémorisation « Sample and Hold » 30, un transistor associé 31 et un amplificateur 32.

Selon l'invention le détecteur 100 comprend en outre les éléments suivants :
- Un démultiplexeur 4 connectant successivement le transducteur 1 sur une tension de référence (Vref) puis sur l'entrée du transistor d'injection (Minj). Ce démultiplexeur comprend des transistors Φ̅*̅*̅_̅{̅g̅a̅t̅i̅n̅g̅}̅*̅*̅ 41 et Φ**_{gating}** 42 qui sont commandés en parfaite opposition de phase afin de minimiser l'injection de charges liée à la fermeture du transistor 41 Φ̅*̅*̅_̅{̅g̅a̅t̅i̅n̅g̅}̅*̅*̅ et son impact sur la modulation de potentiel du noeud d'entrée 24 de l'intégrateur 4.
- Un ampli différentiel inverseur cascodé (A) 20', de grands gain et bande passante, placé dans une boucle de contre réaction entre l'entrée du transistor d'injection 21 et la grille de ce transistor. Cet amplificateur stabilise le potentiel d'entrée du transistor d'injection 21 et en augmente la bande passante. La bande passante de l'ampli est de préférence ajustée par une capacité 25 de contre réaction CBL, pour éviter les oscillations du circuit lors de la détection d'impulsions rapides de grandes amplitudes. Son optimisation est faite en fonction des caractéristiques des impulsions à détecter (amplitude, durée et récurrence).

De préférence, l'intégrateur 2 comprend en outre un transistor écran 26 (Mecr) placé entre la sortie du transistor d'injection 21 (Minj) et la capacité d'intégration 22 (Cint), qui réalise un montage cascode permettant de minimiser la modulation du potentiel du drain du transistor d'injection en fonction de la charge intégrée, augmentant ainsi le découplage entre la capacité d'intégration 22 et l'entrée 24 de l'intégrateur. Avantageusement, ce transistor 26 fonctionne en saturation ce qui limite la décharge maximale du potentiel de la capacité d'intégration 22 à Vecr-Vth-5.ΦT (Vecr= potentiel constant de la grille du transistor écran, Vth= tension de seuil du transistor écran et ΦT=potentiel thermique).

Le transducteur 1 comprend une résistance de fuite (résistance shunt) 12 dont la valeur limite le temps maximal alloué à la détection (constante de temps : (Cdet+Cstray)Rsh) . On a indiqué sur la figure une capacité Cstray 27 pour matérialiser une capacité parasite de l'intégrateur.

Plusieurs impulsions sont ainsi transférées et sommées dans la capacité d'intégration Cint 22 au cours d'une même période de trame. Le résultat de la sommation est ensuite lu en quelques milli-secondes.

Ce détecteur 100 a ainsi comme avantages :
- de ne plus être limité en cadence de détection en raison notamment de la cadence limitée du circuit de lecture ni de réduire la perte d'informations entre 2 impulsions et pouvoir ainsi fonctionner à une cadence d'environ 20 kHz,
- de diminuer la dégradation du rapport signal sur bruit apporté par le bruit additionnel de chaque lecture, puisqu'on a une seule lecture pour plusieurs impulsions détectées puis sommées dans l'intégrateur, grâce à la post-intégration au sein même du détecteur préalablement à sa lecture et non hors plan focal.

Compte tenu de l'amélioration du rapport S/B de chaque photodétecteur, il devient possible de réduire le flux arrivant sur la matrice de photodétecteurs et ainsi de diminuer la taille des optiques utilisées (lentilles, miroirs, hublot) et de réduire l'encombrement global du système.

Le système de brouillage fonctionne de la manière suivante. La poursuite automatique du missile à neutraliser se décompose en une poursuite passive suivie d'une poursuite active.

Dès qu'un missile a été détecté par un détecteur de départ de missile, la tourelle est orientée le plus vite possible pour pointer sa ligne de visée sur la cible désignée. Dès que la cible est dans le champ de vue du détecteur IR 100, les processus d'acquisition et de poursuite sont initiés de manière à garder la ligne de visée pointée en temps réel sur la menace. Le contrôle de la tourelle 120 est assuré par le système de brouillage indépendamment du détecteur de départ de missile. Quand le critère de poursuite passive est validé, c'est-à-dire lorsque la cible est au centre du champ de vue sur plusieurs images successives, la poursuite active prend le relais et le mode brouillage est activé pour détecter les impulsions rétro diffusées par la cible. Ces impulsions sont générées par l'effet « oeil de chat » lorsque la cible est un auto-directeur IR dont le système optique est pointé sur le porteur du système de brouillage. Si le signal détecté n'est pas du type « oeil de chat », la cible peut être une fausse alarme.

Lorsque le signal détecté est du type « oeil de chat », le missile peut alors être neutralisé en modulant le laser de brouillage 110 pour adapter le code de brouillage à celui de l'auto-directeur du missile.

Le missile peut aussi être neutralisé en utilisant un laser d'endommagement à forte puissance aussi désigné laser de destruction.

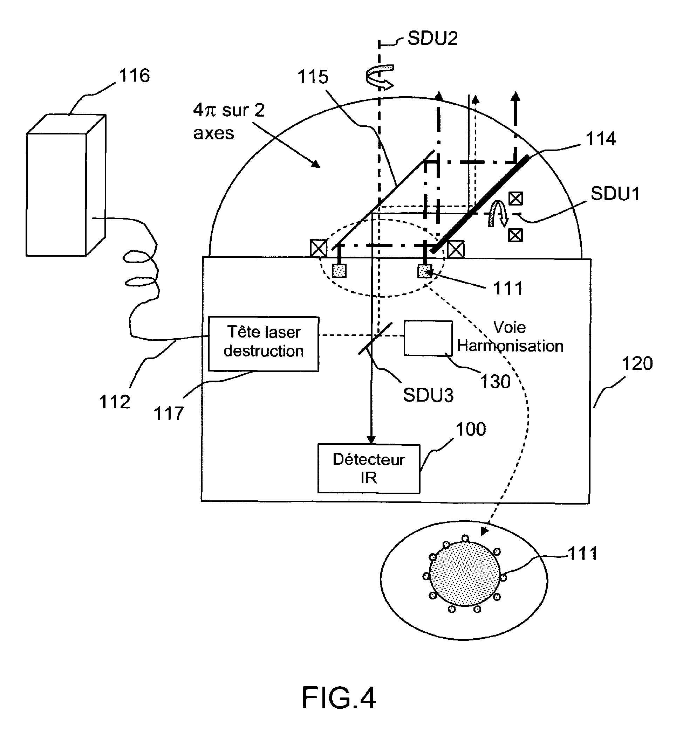

Selon un autre mode d'exploitation de l'invention dont un exemple est montré figure 4, le système de brouillage est complété par un équipement d'endommagement qui comprend bien sûr un dispositif d'émission IR spécifique pour l'endommagement. La tête 117 du laser de destruction est installée dans la tourelle 120, son laser de pompage 116 étant de préférence déporté dans une unité électronique et relié à la tête 117 par une fibre optique 112.

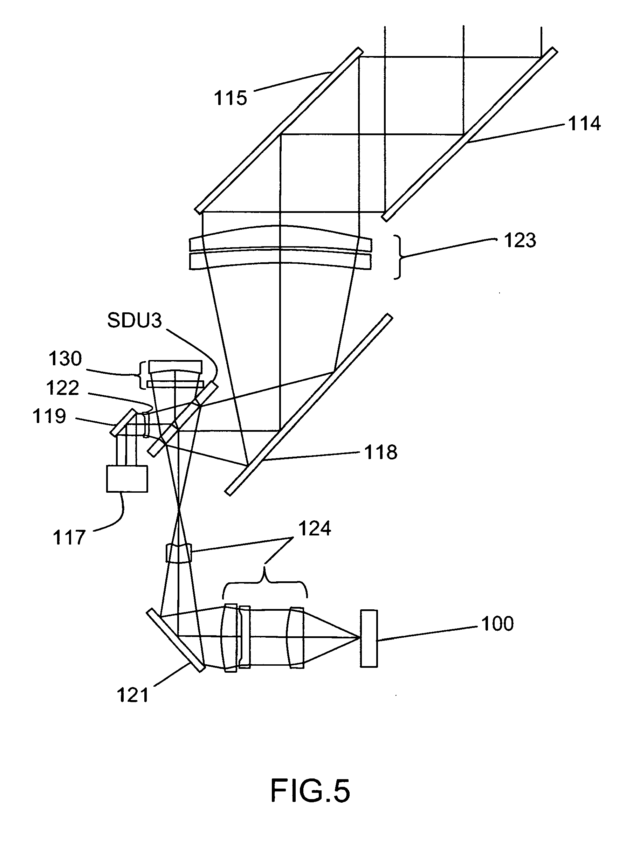

On voit figure 5 un exemple de configuration optique de ce système de brouillage et d'endommagement, prévue pour séparer la tête du laser IR d'endommagement 117, du détecteur IR 100 et assurer un contrôle permanent de l'harmonisation de l'axe de visée du laser d'endommagement avec l'axe du détecteur. A cet effet, le système comporte un dispositif d'harmonisation 130 apte à harmoniser en permanence la voie optique pour le détecteur aussi désignée voie optique d'imagerie (passive et active) et la voie optique pour l'endommagement. Ce dispositif d'harmonisation 130 comprend de manière classique des composants optiques tels que un filtre et une lame réfléchissante ; il est associé à la lame dichroïque de séparation SDU3 et à un détecteur pour harmoniser en permanence les 2 voies. Selon l'invention, ce dispositif d'harmonisation permet d'utiliser le même détecteur 100 pour l'imagerie et pour l'harmonisation du laser d'endommagement car il absorbe suffisamment le rayonnement émis par le laser d'endommagement 117 pour ne pas éblouir le détecteur IR 100. Un oculaire laser 122 est associé au laser 117. Un réimageur de la voie imagerie est assuré par un ensemble de lentilles 124. Plusieurs miroirs de coudage 118, 119 et 121 sont utilisés dans cette configuration. Ce système utilise aussi une seule pupille d'entrée commune pour la voie d'endommagement et la voie optique d'imagerie. Par pupille d'entrée commune on entend le trajet optique commun pour ces deux voies entre le miroir de tête 114 et la lame dichroïque de séparation SDU3 ; un groupe de lentilles de tête 123 est situé sur ce trajet commun.

Cette configuration permet de réduire l'encombrement du système.

On a par exemple les dimensions suivantes. Les diodes mesurent environ 4 mm de diamètre et sont régulièrement réparties sur un cercle d'environ 50 mm de diamètre. Les optiques utilisées pour la voie du laser de destruction ont par exemple un diamètre de l'ordre de 50 mm. La pupille d'entrée a par exemple un diamètre inférieur à 50 mm.

## Revendications

1. Système de brouillage de capteur IR qui comprend :
- un dispositif d'émission IR pour le brouillage, comprenant plusieurs diodes laser (111), chaque diode laser étant apte à émettre à une longueur d'onde λ différente,
- un détecteur (100) d'impulsions comportant une matrice de photo détecteurs IR, chaque photo détecteur comprenant un transducteur (1) et un intégrateur (2),
**caractérisé en ce que**
- chaque diode laser (111) du dispositif d'émission est apte à fonctionner en mode quasi-continu, c'est-à-dire avec un facteur de forme > 0,3,
- et **en ce que** chaque photo détecteur comprend des moyens :
i. d'ouverture de l'intégrateur pendant la réception de chaque impulsion puis d'obturation de l'intégrateur entre deux réceptions,
ii. de sommation des charges intégrées par l'intégrateur sur plusieurs impulsions,
iii. et de lecture de la somme des charges intégrées sur plusieurs impulsions.

2. Système de brouillage selon la revendication précédente, **caractérisé en ce que** les moyens d'ouverture et d'obturation de l'intégrateur comprennent un circuit de démultiplexage (4) intercalé entre le transducteur (1) et l'intégrateur (2).

3. Système de brouillage selon la revendication précédente, **caractérisé en ce que** le circuit de démultiplexage (4) comprend deux transistors Φ̅*̅*̅_̅{̅g̅a̅t̅i̅n̅g̅}̅*̅*̅ (41) et Φ**_{gating}** (42) commandés en opposition de phase.

4. Système de brouillage selon l'une des revendications précédentes, **caractérisé en ce que** l'intégrateur (2) comporte un transistor d'injection (21) MOSFET monté en grille commune, un amplificateur de contre-réaction différentiel inverseur cascodé placé entre l'entrée du transistor d'injection (21) et la grille de ce transistor, une capacité d'intégration (22).

5. Système de brouillage selon l'une des revendications précédentes, **caractérisé en ce que** les diodes laser (111) sont des diodes classe 1.

6. Système de brouillage selon l'une des revendications précédentes, **caractérisé en ce que** les longueurs d'onde des diodes laser (111) sont comprises entre 2 et 5 µm.

7. Système de brouillage selon l'une des revendications précédentes, **caractérisé en ce qu'**il comprend un équipement d'endommagement comportant un dispositif d'émission IR (116, 117) pour l'endommagement.

8. Système de brouillage selon la revendication précédente, **caractérisé en ce qu'**il comprend une voie optique d'imagerie pour la détection et une voie optique pour l'endommagement et **en ce qu'**il comporte un dispositif d'harmonisation (130) comprenant un détecteur IR et des composants optiques aptes à harmoniser en permanence les 2 voies.

9. Système de brouillage selon la revendication précédente, **caractérisé en ce que** le détecteur IR (100) est commun à la voie imagerie et à la voie harmonisation.

10. Système de brouillage selon la revendication précédente, **caractérisé en ce qu'**il comprend une seule pupille d'entrée commune aux deux voies.

11. Système de brouillage selon l'une des revendications précédentes, **caractérisé en ce que** la pupille d'entrée a un diamètre inférieur à 50 mm.

## Patentansprüche

1. System zum Stören eines IR-Sensors, das Folgendes umfasst:
- ein IR-Sendegerät zum Stören, das mehrere Laserdioden (111) umfasst, wobei jede Laserdiode zum Senden mit einer anderen Wellenlänge λ ausgelegt ist;
- einen Impulsdetektor (100), der eine Matrix von IR-Fotodetektoren umfasst, wobei jeder Fotodetektor einen Wandler (1) und einen Integrator (2) umfasst, **dadurch gekennzeichnet, dass**
- jede Laserdiode (111) des Sendegeräts zum Arbeiten in einem quasikontinuierlichen Modus ausgelegt ist, d.h. mit einem Formfaktor von > 0,3,
- und dadurch, dass jeder Fotodetektor Mittel umfasst zum:
i. Öffnen des Integrators beim Empfangen jedes einzelnen Impulses und dann Schließen des Integrators zwischen zwei Empfängen;
ii. Summieren von durch den Integrator integrierten Lasten auf mehreren Impulsen;
iii. und Lesen der Summe von auf mehreren Impulsen integrierten Lasten.

2. Störsystem nach dem vorherigen Anspruch, **dadurch gekennzeichnet, dass** die Mittel zum Öffnen und Schließen des Integrators eine Demultiplexierschaltung (4) umfassen, die zwischen dem Wandler (1) und dem Integrator (2) geschaltet ist.

3. Störsystem nach dem vorherigen Anspruch, **dadurch gekennzeichnet, dass** die Demultiplexierschaltung (4) zwei Transistoren umfasst, Φ_{Gating} (41) und Φ_{Gating} (42), die gegenphasig gesteuert werden.

4. Störsystem nach einem der vorherigen Ansprüche, **dadurch gekennzeichnet, dass** der Integrator (2) einen in Gate-Schaltung montierten MOSFET-Injektionstransistor (21), wobei ein kaskodengeschalteter gegengekoppelter Umkehr-Differentialverstärker zwischen dem Injektionstransistoreingang (21) und dem Gatter des Transistors platziert ist, und einen Integrationskondensator (22) umfasst.

5. Störsystem nach einem der vorherigen Ansprüche, **dadurch gekennzeichnet, dass** die Laserdioden (111) Dioden der Klasse 1 sind.

6. Störsystem nach einem der vorherigen Ansprüche, **dadurch gekennzeichnet, dass** die Wellenlängen der Laserdioden (111) zwischen 2 und 5 µm liegen.

7. Störsystem nach einem der vorherigen Ansprüche, **dadurch gekennzeichnet, dass** es ein Beschädigungsgerät umfasst, das ein IR-Sendegerät (116, 117) zum Beschädigen umfasst.

8. Störsystem nach dem vorherigen Anspruch, **dadurch gekennzeichnet, dass** es einen optischen Bilderzeugungskanal zur Detektion und einen optischen Kanal zum Beschädigen umfasst, und dadurch, dass es ein Harmonisierungsgerät (130) umfasst, das einen IR-Detektor und optische Komponenten umfasst, die zum kontinuierlichen Harmonisieren der zwei Kanäle ausgelegt sind.

9. Störsystem nach dem vorherigen Anspruch, **dadurch gekennzeichnet, dass** der IR-Detektor (100) dem Bilderzeugungskanal und dem Harmonisierungskanal gemeinsam ist.

10. Störsystem nach dem vorherigen Anspruch, **dadurch gekennzeichnet, dass** es eine einzige Einlasspupille aufweist, die den zwei Kanälen gemeinsam ist.

11. Störsystem nach einem der vorherigen Ansprüche, **dadurch gekennzeichnet, dass** der Durchmesser der Einlasspupille geringer als 50 mm ist.

## Claims

1. A system for jamming an IR sensor comprising:
- an IR transmission device for jamming, comprising a plurality of laser diodes (111), with each laser diode being designed to transmit a different wavelength λ;
- a pulse detector (100) comprising a matrix of IR photo-detectors, with each photo-detector comprising a transducer (1) and an integrator (2),
**characterised in that**
- each laser diode (111) of said transmission device is designed to operate in a quasi-continuous mode, i.e. with a form factor of > 0.3,
- and **in that** each photo-detector comprises means:
i. for opening said integrator during the reception of each pulse and then for closing said integrator between two receptions;
ii. for adding loads integrated by said integrator on a plurality of pulses;
iii. and for reading the sum of charges integrated on a plurality of pulses.

2. The jamming system according to the preceding claim, **characterised in that** said means for opening and closing said integrator comprise a demultiplexing circuit (4) interposed between said transducer (1) and said integrator (2).

3. The jamming system according to the preceding claim, **characterised in that** the demultiplexing circuit (4) comprises two transistors, Φ gating (41) and Φ gating (42), which are controlled in phase opposition.

4. The jamming system according to any one of the preceding claims, **characterised in that** said integrator (2) comprises a MOSFET injection transistor (21) mounted as a common gate, a cascode differential inverter type negative-feedback amplifier placed between said injection transistor input (21) and the gate of said transistor, and an integration capacitor (22).

5. The jamming system according to any one of the preceding claims, **characterised in that** said laser diodes (111) are class 1 diodes.

6. The jamming system according to any one of the preceding claims, **characterised in that** the wavelengths of said laser diodes (111) are between 2 and 5 µm.

7. The jamming system according to any one of the preceding claims, **characterised in that** it comprises damaging equipment comprising an IR transmission device (116, 117) for damage.

8. The jamming system according to the preceding claim, **characterised in that** it comprises an optical imaging channel for detection and an optical channel for damage, and **in that** it comprises a harmonisation device (130) comprising an IR detector and optical components designed to continuously harmonise said 2 channels.

9. The jamming system according to the preceding claim, **characterised in that** said IR detector (100) is common to said imaging channel and to said harmonisation channel.

10. The jamming system according to the preceding claim, **characterised in that** it comprises a single inlet pupil common to said two channels.

11. The jamming system according to any one of the preceding claims, **characterised in that** the diameter of said inlet pupil is less than 50 mm.
